# EUROPEAN PATENT APPLICATION

(11) **EP 2 264 781 A1**
(43) Date of publication of application: **22.12.2010**
(21) Application number: 09727036.7
(22) Date of filing: 27.03.2009
(51) Int. Cl.: H01L 31/04, G01R 31/00

(54) **SOLAR CELL MANUFACTURING METHOD, SOLAR CELL MANUFACTURING DEVICE, AND SOLAR CELL**

(30) Priority: 31.03.2008 JP 2008090570
(71) Applicant: ULVAC, INC., Chigasaki-shi Kanagawa 253-8543 (JP)
(72) Inventor: YAMAMURO, Kazuhiro, Chigasaki-shi Kanagawa 253-8543 (JP); SATO, Seiichi, Chigasaki-shi Kanagawa 253-8543 (JP); YAHAGI, Mitsuru, Chigasaki-shi Kanagawa 253-8543 (JP); YUYAMA, Junpei, Chigasaki-shi Kanagawa 253-8543 (JP); NAKAMURA, Kyuzo, Chigasaki-shi Kanagawa 253-8543 (JP)
(74) Representative: Eisenführ, Speiser & Partner
(86) International application number: PCT/JP2009/056249
(87) International publication number: WO 2009/123040

(57) **Abstract**

A method for manufacturing a solar cell, includes: forming a photoelectric converter (12) which includes a plurality of compartment elements (21, 21s), and in which the compartment elements (21, 21s) adjacent to each other are electrically connected; specifying a first compartment element (21s) having a structural defect (R, A1, A2, A3) in the photoelectric converter (12); restricting a portion in which the structural defect exists in the first compartment element (21s) by specifying a defect portion based on a resistance distribution that is obtained by measuring resistances of portions between the compartment elements (21, 21s) adjacent to each other; and removing or separating off the structural defect by irradiating the first compartment element (21s) and a second compartment element (21) with a laser beam so as to intersect a boundary section (19) between the first compartment element (21s) including the portion in which the structural defect exists and the second compartment element (21) adjacent to the first compartment element (21s).

## Description

### BACKGROUND OF THE INVENTION

### Field of the present invention

The present invention relates to a solar cell, a method and an apparatus for manufacturing a solar cell, and specifically relates to a solar cell in which a structural defect is repaired in a minimum range, a method and an apparatus for manufacturing a solar cell that are capable of detecting and repairing a structural defect at a low cost.

This application claims priority from Japanese Patent Application No. 2008-090570 filed on March 31, 2008, the contents of which are incorporated herein by reference in their entirety.

### Background Art

In recent years, in view of efficient use of energy, solar cells are more widely used than ever before.

Specifically, a solar cell in which a silicon single crystal is utilized has a high level of energy conversion efficiency per unit area.

However, in contrast, in the solar cell in which the silicon single crystal is utilized, a silicon single crystal ingot is sliced, a sliced silicon wafer is used in the solar cell; therefore, a large amount of energy is spent for manufacturing the ingot, and the manufacturing cost is high.

Specifically, at the moment, in a case of realizing a solar cell having a large area which is placed out of doors or the like, when the solar cell is manufactured by use of a silicon single crystal, the cost considerably increases.

Consequently, as a low-cost solar cell, a solar cell that can be further inexpensively manufactured and that employs a thin film made of amorphous silicon is in widespread use.

An amorphous silicon solar cell uses semiconductor films of a layered structure that is referred to as a pin-junction in which an amorphous silicon film (i-type) is sandwiched between p-type and n-type silicon films, the amorphous silicon film (i-type) generating electrons and holes when receiving light.

An electrode is formed on both faces of the semiconductor films.

The electrons and holes generated by sunlight actively transfer due to a difference in the electrical potentials between p-type and n-type semiconductors, and a difference in the electrical potentials between the both faces of the electrodes is generated when the transfer thereof is continuously repeated.

As a specific structure of the amorphous silicon solar cell as described above, for example, a structure is employed in which a transparent electrode is formed as a lower electrode by forming TCO (Transparent Conductive Oxide) or the like on a glass substrate, a semiconductor film composed of an amorphous silicon and an upper electrode that becomes an Ag thin film or the like are formed thereon.

In the amorphous silicon solar cell that is provided with a photoelectric converter constituted of the foregoing upper and lower electrodes and the semiconductor film, the difference in the electrical potentials is small if each of the layers having a large area is only uniformly formed on the substrate, and there is a problem in that the resistance increases.

Consequently, the amorphous silicon solar cell is formed by, for example, forming compartment elements so as to electrically separate the photoelectric converter thereinto by a predetermined size, and by electrically connecting adjacent compartment elements with each other.

Specifically, a structure is adopted in which a groove that is referred to as a scribing line is formed on the photoelectric converter having a large area uniformly formed on the substrate by use of a laser light or the like, a plurality of compartment elements formed in a longitudinal rectangular shape is obtained, and the compartment elements are electrically connected in series.

However, in the amorphous silicon solar cell having the foregoing structure, it is known that several structural defects occur during a manufacturing step therefor.

For example, in a forming the amorphous silicon film, the upper electrode and the lower electrode may be locally short-circuited because particles mix thereto or pin holes occur therein.

In addition, when the photoelectric converter that was formed on substrate is divided into a plurality of compartment elements by the scribing line, a metal film that forms the upper electrode is molten and reaches the lower electrode along the scribing line, and the upper electrode and the lower electrode may be locally short-circuited.

In the photoelectric converter as mentioned above, when structural defects occur such that the upper electrode and the lower electrode are locally short-circuited with the semiconductor film interposed therebetween, the defects cause malfunction such that power generation voltage or photoelectric conversion efficiency are degraded.

Consequently, in the process for manufacturing a conventional amorphous silicon solar cell, by detecting the structural defects such as the foregoing short-circuiting or the like and by removing the portions at which the structural defects occur, malfunction is improved.

For example, Japanese Unexamined Patent Application, First Publication No. H09-266322 and Japanese Unexamined Patent Application, First Publication No. 2002-203978 disclose a method for specifying the compartment element in which the structural defects exist, by applying a bias voltage to each of entire compartment element that was separated by the scribing line and by detecting Joule heat being generated at short-circuiting portions by use of an infrared light sensor.

In addition, a method for enlarging and observing a top face of all of compartment elements by use of a CCD camera or the like, or a method for irradiating a compartment element with light, measuring and comparing FF (fill factor) of each thereof, and thereby specifying a compartment element in which the structural defects exist has been also known.

However, in the method for detecting the defects by applying the bias voltage to entire compartment element as described above, it is possible to specify a rough position of the defect in the compartment element, but, it is difficult to specify a fine position thereof, it is necessary to scan therefor by use of an infrared light sensor, there is thereby a problem in that the cost of an apparatus increases for detecting the defect and for a detection precision.

In addition, furthermore, since the bias voltage is applied with a degree such that a defect portion is heated, there is a concern that a semiconductor film is damaged.

In the method for defecting detects by enlarging and observing by use of a CCD camera or the like, it is necessary to scan the entire solar cell using the camera, specifically, in the case where the solar cell has a large area, there is a problem in that the detecting of structural defects is complex and a time therefor is required.

In addition, there is a concern that defects which do not appear on a top layer are not detected.

In the method for irradiating a compartment element with light and measuring FF of each thereof, it is possible to detect a compartment element in which the defects exist, it is difficult to specify as to where the defects exist in the compartment element.

Consequently, in the above-described method for detecting the defects, since only a rough position of the defect is specified, a semiconductor film is removed in a wide region thereof when repairing the defect portions using a laser light or the like; there are problems not only of the solar cell having undesirable characteristics but also causing disfigurement of the solar cell.

In addition, in the case where a rough position of the defect is only specified and the defects are removed by applying the bias voltage, it is necessary to increase the bias voltage.

However, when a high degree of the bias voltage is applied more than necessary, there is a problem in that nondefective portions in which defects do not occur are damaged.

### SUMMARY OF THE INVENTION

The present invention was made with respect to the above-described problems, and has an object to provide a method and an apparatus for manufacturing a solar cell, where portions in which a structural defect is generated are accurately specified in a short time without significantly damaging a photoelectric converter of a solar cell, and it is possible to reliably remove and repair the specified structural defect.

In order to solve the above-described problems, the present invention provides the following method for manufacturing a solar cell.

That is, a method for manufacturing a solar cell of a first aspect of the present invention includes: forming a photoelectric converter which includes a plurality of compartment elements, and in which the compartment elements adjacent to each other are electrically connected; specifying a first compartment element having a structural defect in the photoelectric converter (defect compartment specifying step); restricting a portion in which the structural defect exists in the first compartment element by specifying a defect portion based on a resistance distribution that is obtained by measuring resistances of portions between the compartment elements adjacent to each other (defect portion specifying step); and removing or separating off the structural defect by irradiating the first compartment element and a second compartment element with a laser beam so as to intersect a boundary section between the first compartment element including the portion in which the structural defect exists and the second compartment element adjacent to the first compartment element (repairing step).

It is preferable that, in the method for manufacturing the solar cell of the first aspect of the present invention, when the portion in which the structural defect exists is restricted (defect portion specifying step), the resistances be measured by changing a density of measuring at least two times or more.

In addition, in the measuring of the resistances, a resistance measuring apparatus having four probes is used to measure the resistances.

In addition, the present invention provides the following apparatus for manufacturing a solar cell.

That is, an apparatus for manufacturing a solar cell of a second aspect of the present invention includes: a resistance measuring section that measures resistances of a plurality of portions between the compartment elements adjacent to each other in order to restrict a portion in which a structural defect exists in a first compartment element having the structural defect in the photoelectric converter; and a repairing section that irradiates the first compartment element and a second compartment element with a laser beam so as to intersect a boundary section between the first compartment element including the portion in which the structural defect exists and the second compartment element adjacent to the first compartment element, and that removes or separates off the structural defect.

In addition, the present invention provides the following solar cell.

That is, a solar cell of a third aspect of the present invention includes: a photoelectric converter having a plurality of compartment elements; and an intersection section formed by removing or separating off one of the photoelectric converter, intersecting a boundary section between adjacent compartment elements.

According to the method for manufacturing a solar cell of the first aspect of the present invention, firstly, in the defect compartment specifying step, a solar cell including a compartment element (first compartment element) having a structural defect is sorted out

Consequently, only the sorted solar cell having the defect is transmitted to the defect portion specifying step.

In the defect portion specifying step, a portion in which a defect exists is accurately specified.

In this way, it is possible to effectively manufacture a solar cell without the structural defect.

Furthermore, in the defect portion specifying step, since it is possible to accurately specify a position at which the defect exists in the first compartment element, it is possible to remove only a small-limited region including the defect in the repairing step.

Therefore, it is possible to repair the defect portions without significantly degrading the characteristics of the solar cell, and without causing disfigurement thereof.

Consequently, in the repairing step, the first compartment element and a second compartment element are irradiated with the laser beam so that the laser beam intersects the boundary section between the first compartment element including the portion in which the structural defect exists, and the second compartment element adjacent to the first compartment element; and the structural defect is removed or separated off.

For this reason, even if the structural defect exists, for example, in the vicinity of a scribing line (boundary section), only a part of the photoelectric converter having the extremely limited width is removed; and it is possible to repair the structural defect almost without affecting the photoelectric conversion efficiency.

In addition, according to the apparatus for manufacturing a solar cell of the second aspect of the present invention, in order to specify the position of the structural defect, since the resistance measuring section measuring resistances of the plurality of portions between the compartment elements is provided, it is possible to accurately specify the positions in which the defects exist in the compartment element.

Furthermore, it is possible to remove only a small-limited region including the defect in the repairing step; and it is possible to repair the defect portions without significantly degrading the characteristics of the solar cell, and without causing disfigurement thereof.

### BRIEF DESCRIPTION OF THE DRAWINGS

FIG. 1 is an enlarged perspective view showing an example of a main section of an amorphous silicon type solar cell.
FIG. 2 is a cross-sectional view showing an example of the amorphous silicon type solar cell.
FIG. 3 is a flowchart schematically illustrating a method for manufacturing the solar cell of the present invention.
FIG. 4 is a cross-sectional view showing an example of a structural defect existing and a condition after the defect was repaired.
FIG. 5 is an explanatory diagram showing a condition of a defect compartment specifying step.
FIG. 6 is a view showing an example of measuring the resistance in the defect compartment specifying step.
FIG. 7 is an explanatory diagram showing a condition of a defect portion specifying step.
FIG. 8 is a view showing an example of measuring the resistance in the defect portion specifying step.
FIG. 9 is an explanatory diagram illustrating an example of a repairing step.
FIG. 10 is an explanatory diagram illustrating an example of the defect portion specifying step.

### DESCRIPTION OF THE PREFERRED EMBODIMENTS

Hereinafter, a method for manufacturing a solar cell related to the present invention, and an apparatus for manufacturing a solar cell of the present invention used in the method will be described with reference to drawings.

The embodiment is specifically explained for appropriate understanding the scope of the present invention, and does not limit the present invention unless otherwise specified.

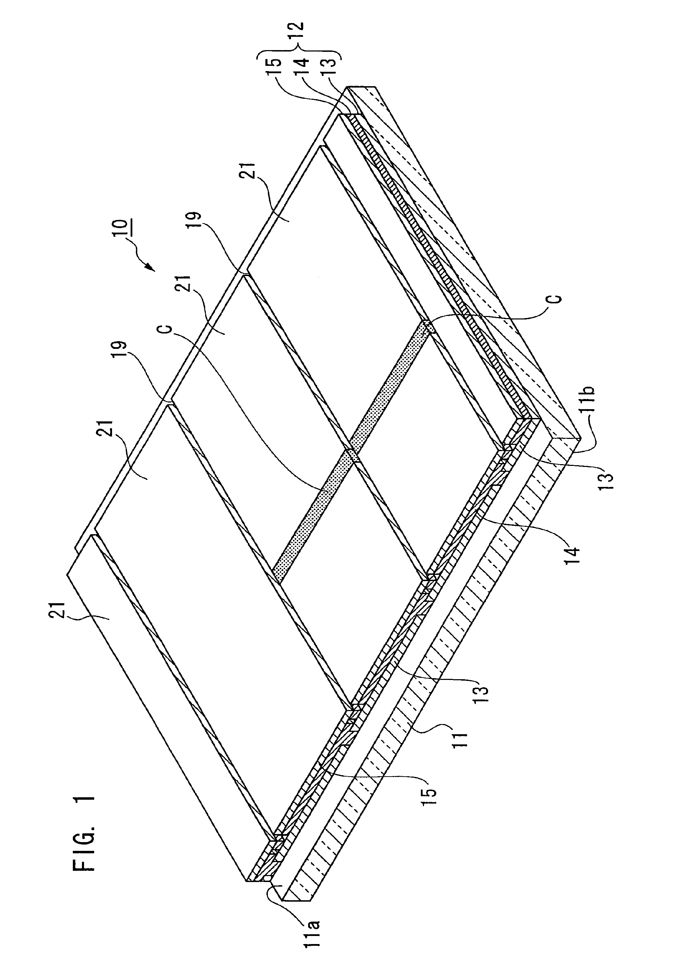

FIG. 1 is an enlarged perspective view showing an example of a main section of an amorphous silicon type solar cell which is manufactured by a method for manufacturing a solar cell of the present invention.

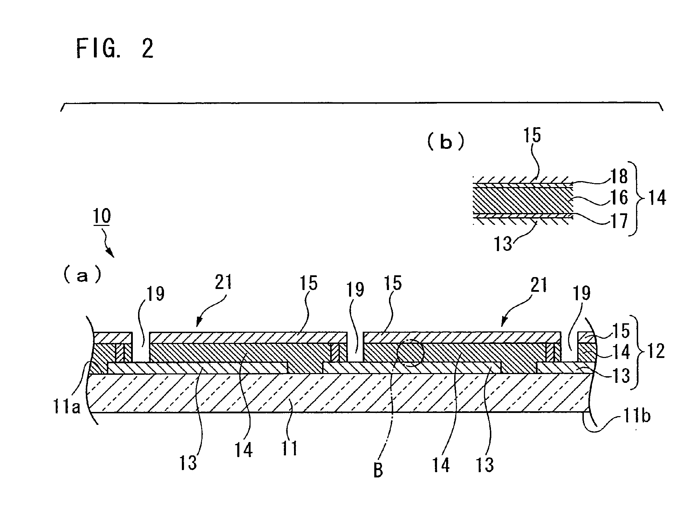

In addition, FIG. 2 (a) is a cross-sectional view showing a layered structure of the solar cell shown in FIG. 1.

FIG. 2 (b) is an enlarged cross-sectional view showing portion indicated by reference numeral B in FIG. 2 (a).

A solar cell 10 has a photoelectric converter 12 formed on a first face 11a (one of faces) of a transparent substrate 11 having an insulation property.

The substrate 11 may be formed of an insulation material having a high level of sunlight transparency and durability such as a glass or a transparent resin.

Sunlight is incident to a second face 11b (the other of faces) of the substrate 11.

In the photoelectric converter 12, a first electrode layer 13 (lower electrode), a semiconductor layer 14, and a second electrode layer 15 (upper electrode) are stacked in layers in order from the substrate 11.

The first electrode layer 13 (lower electrode) may be formed of a transparent conductive material such as, for example, an oxide of metal having an optical transparency such as TCO or ITO (Indium Tin Oxide).
In addition, the second electrode layer 15 (upper electrode) may be formed of a conductive metal film such as Ag or Cu.

As shown in FIG. 2 (b), the semiconductor layer 14 has, for example, a pin-junction structure in which an i-type amorphous silicon film 16 is formed and sandwiched between a p-type amorphous silicon film 17 and an n-type amorphous silicon film 18.

Consequently, when sunlight is incident to the semiconductor layer 14, electrons and holes are generated, electrons and holes actively transfer due to a difference in the electrical potentials between the p-type amorphous silicon film 17 and the n-type amorphous silicon film 18; and a difference in the electrical potentials between the first electrode layer 13 and the second electrode layer 15 is generated when the transfer thereof is continuously repeated (photoelectric conversion).

The photoelectric converter 12 is divided by scribing lines 19 (scribing line, boundary section) into a plurality of compartment elements 21, 21... whose external form is longitudinal rectangular shape.

The compartment elements 21, 21... are electrically separated from each other, and adjacent compartment elements 21 are electrically connected in series therebetween.

In this structure, the photoelectric converter 12 has a structure in which all of the compartment elements 21, 21... are electrically connected in series.

In the structure, it is possible to extract an electrical current with a high degree of difference in the electrical potentials.

The scribing lines 19 are formed, for example, by forming grooves with a predetermined distance therebetween on the photoelectric converter 12 using a laser beam or the like after the photoelectric converter 12 was uniformly formed on the first face 11a of the substrate 11.

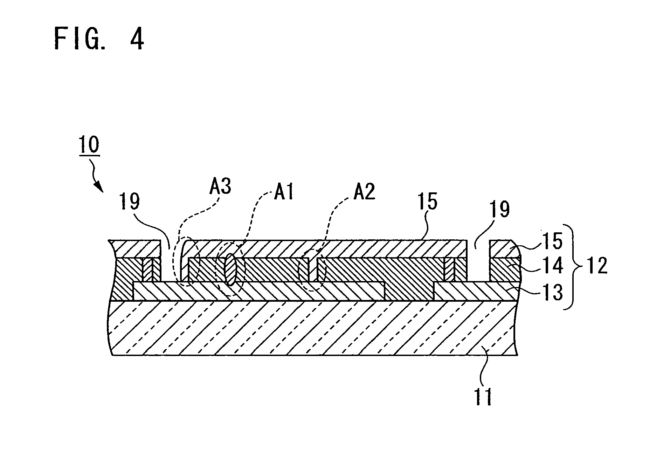

In the solar cell 10 having the foregoing structure, when the scribing lines 19 is formed, there is a case where malfunction is generated such as a structural defect A3 or the like which is generated and caused by the metal constituting the second electrode layer 15 being molten due to discrepancy in irradiated positions with the laser and by falling the molten metal downward the groove of the scribing line 19 (refer to reference numeral A3 in FIG. 4.

The foregoing defects which are generated in the vicinity of the scribing line 19 between adjacent compartment elements 21 and 21 is locally removed by the laser beam that crosses over the scribing line 19 between adjacent compartment elements 21 and 21 of a part of the photoelectric converter 12.

Consequently, a repaired portion C (intersection section) that crosses over adjacent compartment elements 21 and 21 is formed.

The repaired portion C is formed by removing a part of the photoelectric converter 12, and intersects the scribing line 19 between adjacent compartment elements 21 and 21.

In addition, the step for repairing the foregoing structural defect will be described below.

In addition, it is preferable that a protective layer (not shown) made of a resin of insulation or the like be further formed on the second electrode layer 15 (upper electrode) constituting the foregoing photoelectric converter 12.

A manufacturing method for manufacturing a solar cell having the foregoing structure will be described.

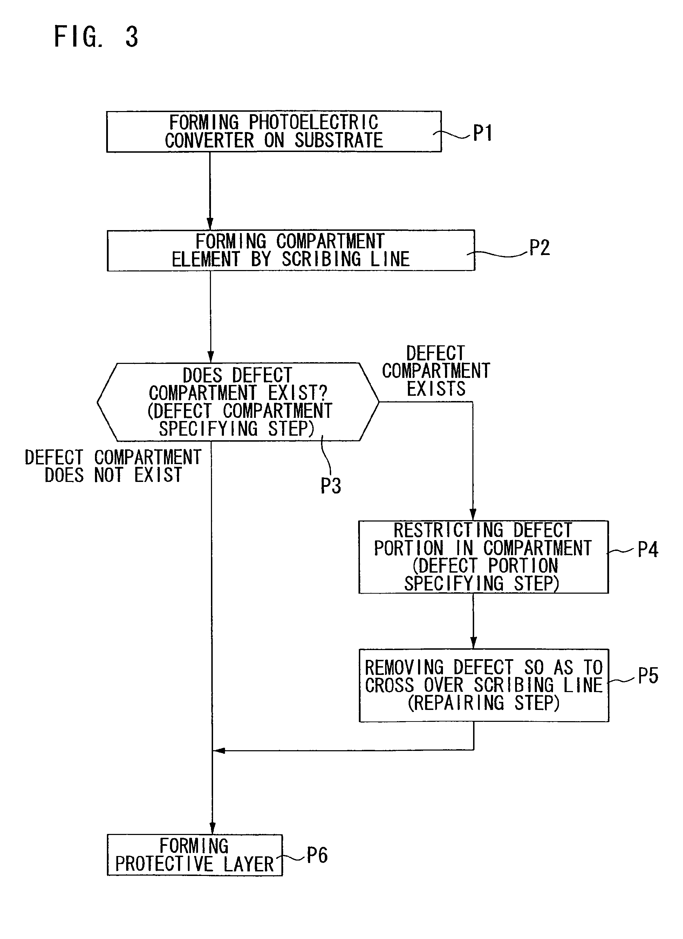

FIG. 3 is a flowchart illustrating a method for manufacturing the solar cell of the first embodiment in a stepwise manner.

In the method, specifically, steps between a step of detecting a structural defect and a step of repairing will be described in detail.

Firstly, as shown in FIG. 1, a photoelectric converter 12 is formed on a transparent first face 11a of a substrate 11 (photoelectric converter formation step : P1).

The structure of the photoelectric converter 12 may be, for example, a structure in which a first electrode layer 13 (lower electrode), a semiconductor layer 14, and a second electrode layer 15 (upper electrode) are stacked in layers in order from the first face 11a of the substrate 11.

In the step of forming the foregoing photoelectric converter 12, as shown in FIG. 4 (a), there is a case where malfunction is generated such as a structural defect A1 which is generated and caused by mixing impurities or the like into the semiconductor layer 14 (contamination) or a structural defect A2 at which microscopic pin holes are generated in the semiconductor layer 14.

The foregoing structural defects A1 and A2 cause the first electrode layer 13 and the second electrode layer 15 to be locally short-circuited (leakage) therebetween, and degrade the power generation efficiency.

Next, scribing lines 19 (scribing line) are formed by irradiating the photoelectric converter 12, for example, with a laser beam or the like; the photoelectric converter 12 is divided into a plurality of compartment elements 21, 21... which are formed in a longitudinal rectangular shape (compartment element formation step : P2).

In the foregoing step of forming the scribing lines 19, there is a case where malfunction is generated such as a structural defect A3 or the like which is generated and caused by the metal constituting the second electrode layer 15 being molten due to discrepancy in irradiated positions with the laser and by falling the molten metal downward the groove of the scribing line 19 as shown FIG. 4.

The foregoing structural defect A3 causes the first electrode layer 13 and the second electrode layer 15 to be locally short-circuited (leakage) therebetween, and degrade the power generation efficiency.

In the solar cell 10 formed by the steps as describe above, firstly, the compartment elements 21, 21... in which the structural defects exist such as the above-described A1 to A3 are specified (defect compartment specifying step : P3).

In the defect compartment specifying step, as a specific method for specifying the compartment elements 21, 21... in which the structural defects exist, for example, measuring of the resistance, measuring of FF (fill factor), or the like are adopted.

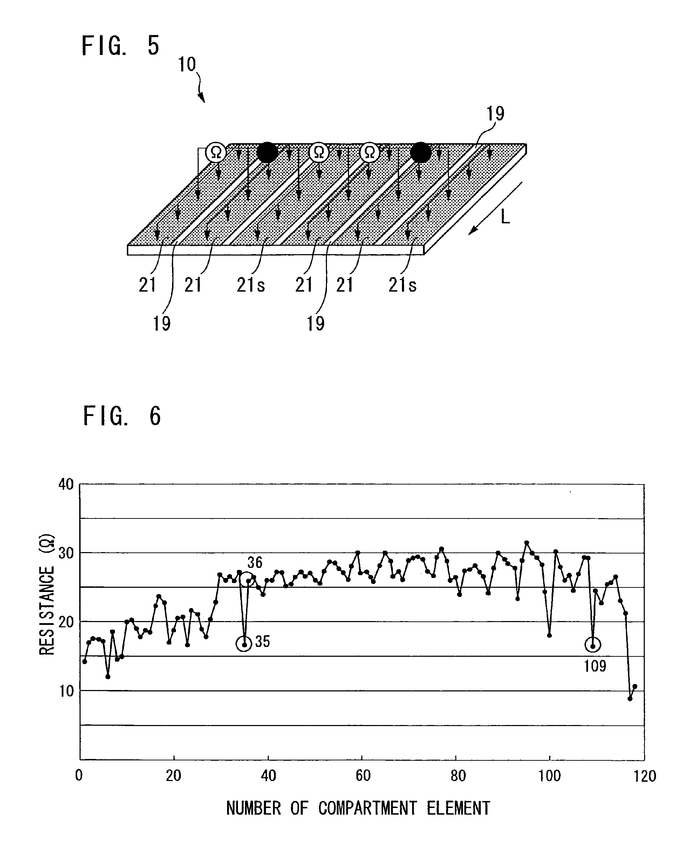

In the case where the compartment elements in which the structural defects exist 21 are specified by measuring the resistance, as shown in FIG. 5, several measuring points are set along the longitudinal direction L of the compartment element 21 formed in a longitudinal rectangular shape, resistances are measured between adjacent compartment elements 21 and 21, and it is thereby possible to specify the compartment element 21s in which the structural defects exist (defect compartment element, first compartment element) based on the distribution of the measured values.

FIG. 6 shows an example of the resistances measured between adjacent compartment elements in the solar cell that is constituted of, for example, 120 compartment elements.

According to the measurement result shown in FIG. 6, by comparing the resistances of compartment element 35 and compartment element 36, it is obvious that the resistance of the compartment element 35 is smaller than the resistance of the compartment element 36.

That is, it is predicted that a structural defect causing short-circuiting exists in the thirty-fifth compartment element.

Similarly, the existence of a structural defect in compartment element 109 is also predicted.

In the foregoing defect compartment specifying step, in the case of specifying the compartment element in which the structural defects exist by measuring the resistance, several methods are adopted as a measuring method.

For example, by use of a measuring apparatus in which a plurality of probes is arrayed along the longitudinal direction L of the compartment element 21 by a predetermined distance, a method in which the resistance between compartment elements is completed by once moving the probe vertically, or a measuring method in which the probe is scanned along the longitudinal direction L of the compartment element 21 by repeatedly moving the probe vertically at a predetermined measuring point, or the like may be used.

In the measuring of the resistance in the foregoing defect compartment specifying step, any of methods may be used, such as a method for applying a predetermined bias voltage, a method of using two probes that constitute a pair thereof and that are used for performing both of the measuring of the resistance and the measuring of an electrical current value, or a method of using four probes that constitute two pairs thereof in which probes used for applying a predetermined bias electrical current are different from probes used for measuring a voltage value.
A resistance is calculated based on the voltage value and the electrical current value.

In addition, in the foregoing defect compartment specifying step, except for the method for measuring the resistance, a method may be adopted in which, for example, a solar cell is irradiated with illumination light of a predetermined light quantity, FF (fill factor) of each compartment element is measured, the FF values of adjacent compartment elements are compared, and a compartment element in which the FF value thereof is specifically reduced is specified as the compartment element in which the structural defects exist.

In this case, particularly, a compartment element in which the FF value thereof is specifically reduced is specified as the compartment element in which the structural defects exist.

After the defect compartment specifying step described above, the solar cell in which the compartment element in which the structural defects exist is found is subsequently transmitted to a defect portion specifying step.

In contrast, a solar cell in which the compartment element in which the structural defects exist is not found is determined as a non-defective product, is passed through a protective layer formation step P6 or the like without modification, and is a commercial reality.

In the above-described defect compartment specifying step, the solar cell in which the compartment element in which the structural defects exist is found is furthermore transmitted to a step for restricting a portion in which a structural defect exists in the compartment element (defect portion specifying step : P4).

In the defect portion specifying step, regarding only the compartment element that is identified as the structural defect existing in the previous step that is the defect compartment specifying step, a resistance between adjacent compartment elements 21 is measured along the longitudinal direction L of the compartment element.

Here, the measuring of the resistances is performed so that a measurement interval (degree of density for measuring) at which the resistances are measured in the longitudinal direction L is smaller than the measurement interval at which the resistances were measured in the previous step that is the defect compartment specifying step.

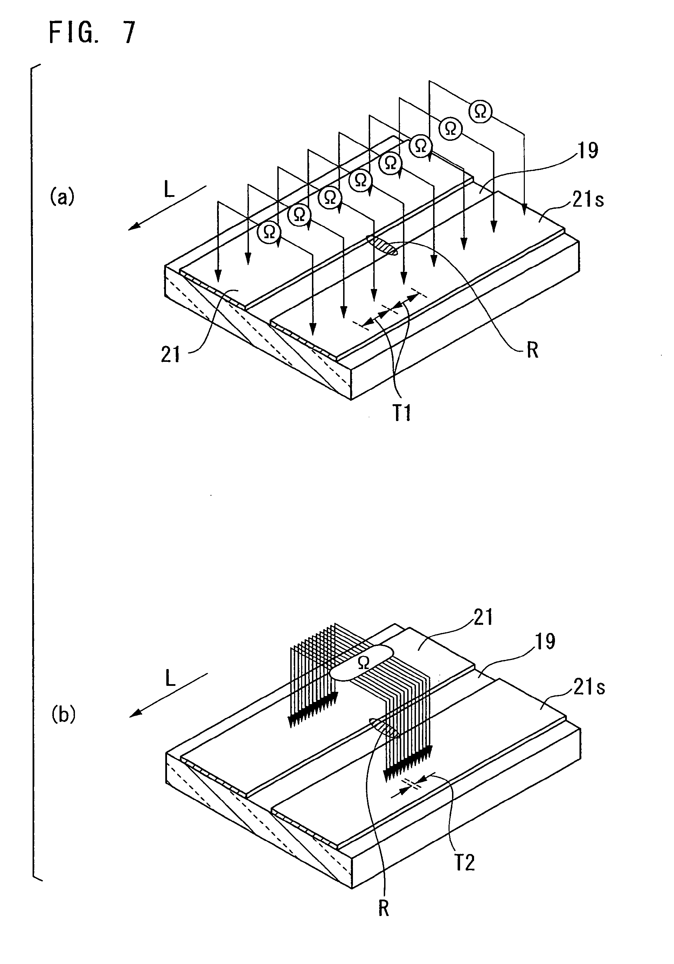

As shown in FIG. 7 (a), for example, in the entire area in the longitudinal direction L of the compartment element 21s that is identified as the structural defect R existing, the measuring of the resistance is performed between adjacent compartment elements 21 by a predetermined measurement interval T1 (degree of density for measuring) at which the resistances are measured.

By measuring the resistances, a rough position of the structural defect R is specified in the longitudinal direction L of the compartment element 21s.

The measurement interval T1 at which the resistances are measured may be, for example, approximately 20 mm.

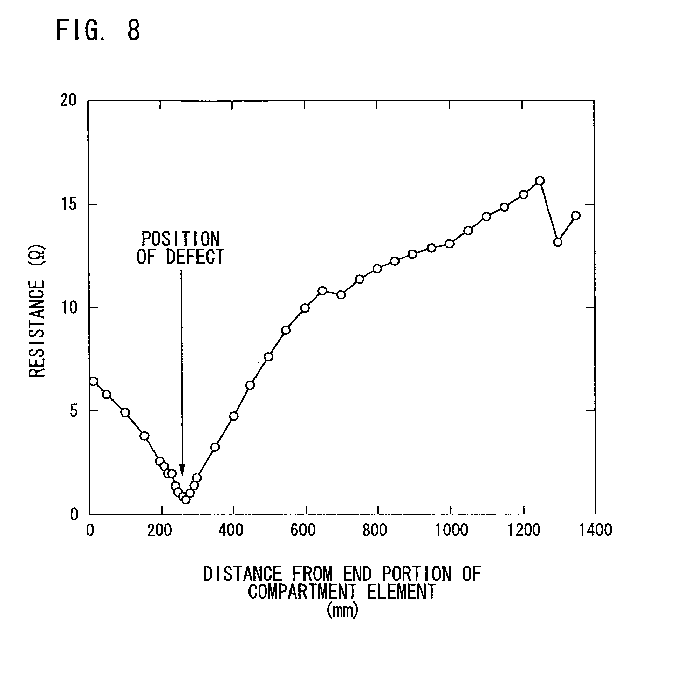

In the compartment element that is formed in a longitudinal rectangular shape and that has, for example, 1400 mm of length in the longitudinal direction L (one defect exists therein), an example of measuring the resistance between adjacent compartment elements is shown in FIG. 8.

According to the measurement result shown in FIG. 8, the resistance is reduced in a direction from an end portion of the compartment terminals toward adjacent 250 mm in the distance.

In the case mentioned above where the structural defect causing the short-circuiting exists, the resistance is gradually reduced as the position at which the defect exists is approached.

Therefore, by observing changes in resistances while measuring the resistances in the longitudinal direction L of the compartment element 21s with a predetermined interval, it is possible to restrict as to which positions the structural defect exists in the compartment element 21s.

As described above, it is preferable that, after a rough position of the structural defect R was specified in the longitudinal direction L of the compartment element 21s, a position at which the structural defect R exists be further accurately specified.

Namely, as described above, it is preferable that, after a rough position of the structural defect R was specified in the longitudinal direction L of the compartment element 21s, the resistances between adjacent compartment elements be measured by the measurement interval T2 that is further smaller than the above-described measurement interval T1 at an area between front and rear positions of the rough position, approximately 100 mm (refer to FIG. 7 (b)).

The measurement interval T2 is set to, for example, approximately 2 mm, and the position at which the structural defect R exists is accurately specified with approximately ten times the degree of accuracy of the above-described step for specifying the rough position of the defect.

In the measuring of the resistance of the foregoing defect portion specifying step, any of methods may be used, such as a method for applying a predetermined bias voltage, a method of using two probes that constitute a pair thereof and that are used for performing both of the measuring of the resistance and the measuring of an electrical current value, or a method of using four probes that constitute two pairs thereof in which probes used for applying a predetermined bias electrical current are different from probes used for measuring a voltage value.

A resistance is calculated based on the voltage value and the electrical current value.

In addition, regarding the foregoing defect portion specifying step in the present embodiment, the position of the defect is specified by twice changing the measurement interval at which the resistances are measured in the embodiment, however, the position of the defect in the compartment element may be further accurately specified by changing the measurement interval at three times or more.

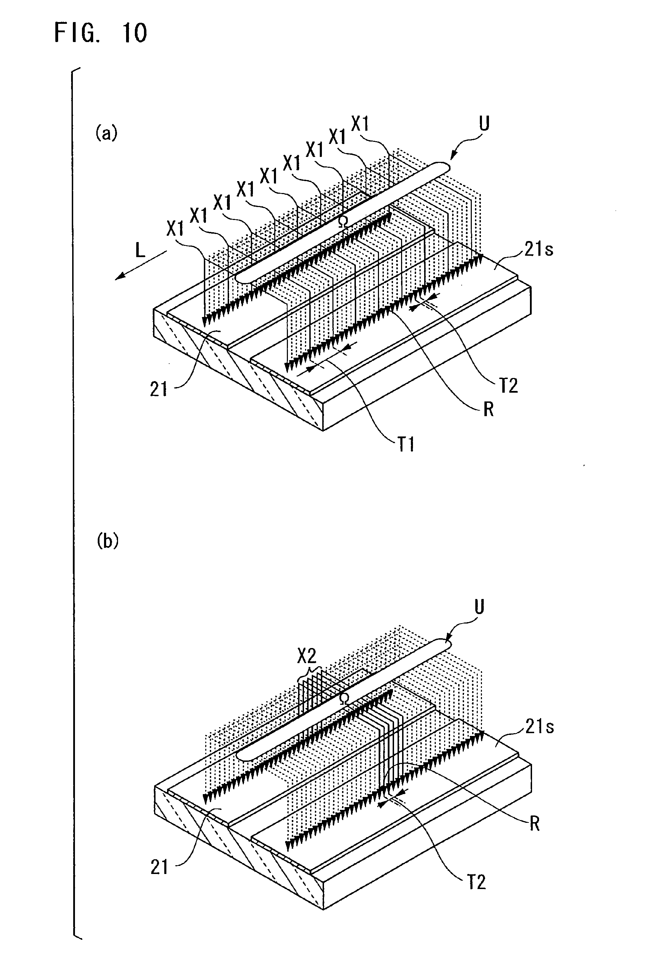

In contrast, in the above-described defect portion specifying step (P4), as shown in FIG. 10 (a), a probe unit U in which a plurality of probes are formed along the longitudinal direction L of the compartment element 21s by the measurement interval T2 may be used.

Firstly, a bias electrical current (voltage) is intermittently applied to only a probe X1 for each a predetermined wide measurement interval T1, and a rough position of the structural defect R is thereby specified.

Subsequently, as shown in FIG. 10 (b), a bias electrical current (voltage) is applied to a probe X2 disposed at a zone that is identified as the structural defect R existing, that is, the zone in which the resistance is lowest in the probes to which a bias electrical current (voltage) is applied.

Here, since the measuring is performed by the measurement interval T2 that is an interval between the formed probes and that is narrower than the initial-wide measurement interval T1, the position of the structural defect R is further accurately specified in the compartment element.

As mentioned above, by use of the probe unit U in which the probes are thickly arrayed along the longitudinal direction L of the compartment element 21s by the measurement interval T2 and by appropriately changing the probe that applies the bias electrical current (voltage), it is possible to quickly detect the position of the structural defect R by only selecting the probe supplying the bias electrical current without the probe being moved in the longitudinal direction L.

In addition, as another detection method, a method for changing the interval between measurement terminals during measuring may be adopted.

In the case of using, for example, an apparatus shown in FIGS. 10 (a) and (b), initially, the interval between the terminals is set to relatively large and the resistances are measured; if a resistance that is lower than a threshold value is detected or if the resistance became lower than a predetermined percentage thereof, the interval between the terminals is set to be narrow, and the resistances are measured for each of the terminals.

In the measuring for each of the terminals, if the resistance is higher than the threshold value or back to the normal value, the interval is back to the original interval, and the measuring is performed.

In addition, as another detection method, a method of determining a plurality of threshold values and of changing the interval between the terminals for each of the threshold values may be adopted.

The threshold values, for example, A, B, and C (A>B>C) of resistance are determined in advance.

If the resistance is greater than or equal to the threshold value A, the measuring is performed while using terminals and spacing ten terminals; if the resistance is less than or equal to threshold value A, the measuring is performed while using terminals and spacing five terminals; if the resistance is less than or equal to threshold value B, the measuring is performed while using terminals and spacing two terminals; and if the resistance is less than or equal to threshold value C, the measuring is performed while using each of terminals.

If the resistance is high, conversely, by increasing the measurement interval each time the resistance exceed the threshold value, the measuring is performed.

If the defects exist, the resistances gradually vary (refer to FIG. 8); therefore, by changing the measurement interval every of threshold value as described above, it is possible to quickly and accurately detect the positions of the defects.

In addition, in the foregoing detection method, the case of using the apparatus is described, in which a plurality of terminals is arrayed as shown in FIG. 10, and the interval between the terminals used for measuring is changed.

In the case of measuring while moving the terminals, a method of changing the measurement interval or the moving speed thereof for each threshold value is realizable.

After the accurate position of the structural defect R was accurately specified in the longitudinal direction L of the compartment element 21s, subsequently, the structural defect R of the solar cell is repair (repairing step : P5).

In the embodiment, for example, it is envisaged that the structural defect R is generated in the vicinity of the scribing line 19 between adjacent compartment elements 21 in the compartment element 21s due to discrepancy in irradiated positions with the laser.

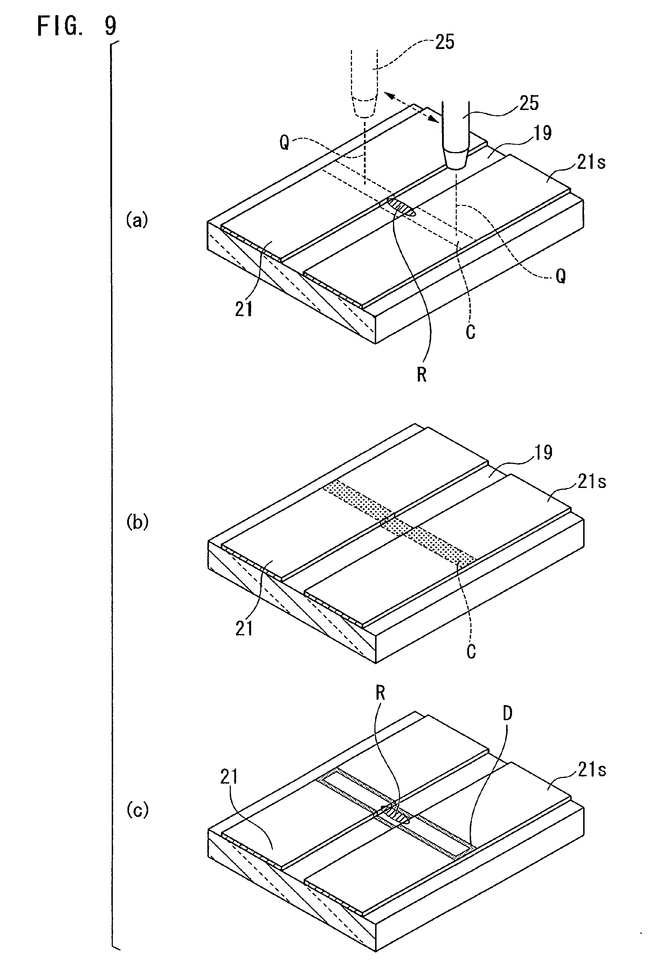

In the repairing step, in order to remove (repair) the structural defect R exists in the vicinity of the scribing line 19 between adjacent compartment elements 21, the compartment element 21s and the compartment element 21 are irradiated with a laser beam Q (refer to FIG. 9(a)) so as to intersect the scribing line 19 between the compartment element 21s (first compartment element) including the portion in which the structural defect R exists and the compartment elements 21 (second compartment element) adjacent to the compartment element 21s.

As described above, due to irradiating the compartment element 21s including the portion in which the structural defect R exists and the compartment elements 21 adjacent the compartment element 21s with the laser beam Q so as to intersect the scribing line 19, the photoelectric converter constituted of the semiconductor layer, the electrodes, or the like is evaporated and removed (refer to FIG. 9 (b)), in the portion in which the structural defect R exists, the structural defect R having a narrow and limited width and being formed in the vicinity of the scribing line 19.

Consequently, the repaired portion C that crosses over adjacent compartment elements 21s and 21 is formed.

Since the positions in which the defects exist is accurately specified in the compartment element in the defect portion specifying step, it is possible to remove only the small-limited repaired portion C that includes the structural defect R formed in the vicinity of the scribing line 19 in the repairing step.

In addition, in the repairing step P5, not only the structural defect formed in the vicinity of the scribing line 19 (refer to reference numeral A3 of FIG. 4) but also the structural defect generated which is caused by contamination being mixed thereto during formation of the photoelectric converter (refer to reference numeral A1 of FIG. 4), the structural defect in which a micro pin hole is generated on the semiconductor layer (refer to reference numeral A2 of FIG. 4), or the like is removed (repaired) due to irradiation with the laser beam, and malfunction is prevented from being generated which is caused by local short-circuiting (leakage).

In addition, in the repairing step, as shown in FIG. 9 (c), the compartment element 21s and the compartment elements 21 adjacent the compartment element 21s may be irradiated with the laser beam Q so as to surround the portion in which the structural defect R exists and so as to intersect the scribing line 19.

In this case, the photoelectric converter constituted of the semiconductor layer, the electrodes, or the like is evaporated and removed so as to surround the portion in which the structural defect R exists and is formed in the vicinity of the scribing line 19.

For this reason, due to the repaired portion D (intersection section) formed in a shape of frame, the structural defect R is electrically separated from the periphery region thereof.

Namely, even if the structural defect R is not directly removed, it is possible to exclude an affect of drawback such as leakage caused by the structural defect R.

The repaired portion D is formed by separating a portion of the photoelectric converter 12 therefrom, and intersects the scribing line 19 between adjacent compartment elements 21 and 21.

As described above, after the defect compartment specifying step (P3), the defect portion specifying step (P4), and the repairing step (P5), the structural defect that exists in the compartment element of the solar cell is specified and removed or separated off

The solar cell in which the structural defect is removed or separated off is transmitted to the protective layer formation step (P6); and the solar cell is processed in post-steps.

According to the foregoing the method for manufacturing a solar cell of the present invention as described above, firstly, in the defect compartment specifying step, a solar cell including a compartment element having a structural defect is sorted out.

Consequently, only the sorted solar cell having the defect is transmitted to the defect portion specifying step.

Since the portions in which a defect exists is accurately specified in the defect portion specifying step, it is possible to effectively manufacture a solar cell without the structural defect.

Furthermore, since it is possible to accurately specify the positions at which the defect exists in the compartment element in the defect portion specifying step, it is possible to remove only the small-limited region including the defect in the repairing step.

Therefore, it is possible to repair the defect portions without significantly degrading the characteristics of the solar cell, and without causing disfigurement thereof.

Consequently, the first compartment element 21s and the second compartment element 21 are irradiated with the laser beam Q so that the laser beam Q intersects the scribing line 19 between the first compartment element 21s including the portion in which the structural defect exists, and the second compartment element adjacent to the first compartment element21s; therefore, even if the structural defect exists, for example, in the vicinity of a scribing line, only a part of the photoelectric converter having the extremely limited width is removed; and it is possible to repair the structural defect almost without affecting the photoelectric conversion efficiency.

In order to specify the position of the structural defect E, the apparatus for manufacturing a solar cell of the present invention may have a resistance measuring section measuring the resistances of the plurality of portions between the compartment elements 21 in the defect portion specifying step shown in FIGS. 7 (a) and (b).

The foregoing resistance measuring section may be constituted of two-probe type or four-probe type resistance measuring apparatus, and a transfer apparatus causing to move the probes relative to the compartment element 21 along the length direction L.

Consequently, in the repairing step shown in FIGS. 9 (a) to (c), as a repairing section irradiating the first compartment element 21s and the second compartment element 21 with the laser beam Q so as to intersect the scribing line 19, for example, a laser apparatus 25 may be provided.

The foregoing repairing section may be further provided with a scanning mechanism scanning with a laser beam in a predetermined range, or provided with a transfer table on which a solar cell that is to be repaired is mounted and which horizontally transfer the solar cell.

### Industrial Applicability

As described above in detail, the present invention is applicable to a method and an apparatus for manufacturing a solar cell, where a damage to a photoelectric converter of a solar cell is suppressed, portions in which a structural defect is generated are accurately specified, and the specified structural defects can be reliably removed and repaired.

## Claims

1. A method for manufacturing a solar cell, comprising:
forming a photoelectric converter which includes a plurality of compartment elements, and in which the compartment elements adjacent to each other are electrically connected;
specifying a first compartment element having a structural defect in the photoelectric converter;
restricting a portion in which the structural defect exists in the first compartment element by specifying a defect portion based on a resistance distribution that is obtained by measuring resistances of portions between the compartment elements adjacent to each other; and
removing or separating off the structural defect by irradiating the first compartment element and a second compartment element with a laser beam so as to intersect a boundary section between the first compartment element including the portion in which the structural defect exists and the second compartment element adjacent to the first compartment element.

2. The method for manufacturing a solar cell according to claim 1, wherein
when the portion in which the structural defect exists is restricted, the resistances are measured by changing a density of measuring at least two times or more.

3. The method for manufacturing a solar cell according to claims 1 or 2, wherein
when the portion in which the structural defect exists is restricted, a resistance measuring apparatus having four probes is used to measure the resistances.

4. An apparatus for manufacturing a solar cell including a photoelectric converter having a plurality of compartment elements, the apparatus comprising:
a resistance measuring section that measures resistances of a plurality of portions between the compartment elements adjacent to each other in order to restrict a portion in which a structural defect exists in a first compartment element having the structural defect in the photoelectric converter; and
a repairing section that irradiates the first compartment element and a second compartment element with a laser beam so as to intersect a boundary section between the first compartment element including the portion in which the structural defect exists and the second compartment element adjacent to the first compartment element, and that removes or separates off the structural defect.

5. A solar cell comprising:
a photoelectric converter having a plurality of compartment elements; and
an intersection section formed by removing or separating off one of the photoelectric converter, intersecting a boundary section between adjacent compartment elements.
